# EUROPEAN PATENT APPLICATION

(11) **EP 4 142 152 A1**
(43) Date of publication of application: **01.03.2023**
(21) Application number: 21792440.6
(22) Date of filing: 20.04.2021
(51) Int. Cl.: H03H 3/02, H03H 9/02, H03H 9/17

(54) **FILTER, BULK ACOUSTIC WAVE RESONATOR ASSEMBLY AND METHOD FOR MANUFACTURING SAME, AND ELECTRONIC DEVICE**

(30) Priority: 21.04.2020 CN 202010314867
(71) Applicant: ROFS MICROSYSTEM (TIANJIN) CO., LTD., Tianjin 300462 (CN)
(72) Inventor: XU, Yang, Tianjin 300462 (CN); PANG, Wei, Tianjin 300072 (CN); HAO, Long, Tianjin 300072 (CN)
(74) Representative: Ström & Gulliksson AB
(86) International application number: PCT/CN2021/088485
(87) International publication number: WO 2021/213402

(57) **Abstract**

Provided is a filter, including: a plurality of serial resonators, and a plurality of parallel resonators, wherein each resonator comprises a substrate (101), an acoustic mirror (103), a bottom electrode (102), a top electrode (106), and a piezoelectric layer (104). The top electrode (106) of at least one serial resonator and the top electrode (106) of at least one parallel resonator have or are provided with raised portions respectively at a connecting end of the top electrode (106) and a connecting end of a non-top electrode, and the top surface of the raised portion is beyond the top surface of an inner side portion of the top electrode (106). Each resonator having the raised portion includes a conductive layer which is in contact with the corresponding electrode in the thickness direction of the resonator, wherein the conductive layer enables the raised portion to be beyond the top surface of the inner side portion of the top electrode (106), and the thickness of the conductive layer of the at least one serial resonator is greater than the thickness of the conductive layer of the at least one parallel resonator. Moreover, the present application further relates to a bulk acoustic wave resonator assembly and a method for manufacturing the bulk acoustic wave resonator assembly.

## Description

### TECHNICAL FIELD

Embodiments of the present disclosure relate to the field of semiconductors, and in particular, to a filter, a bulk acoustic wave resonator assembly and a method of manufacturing the same, and an electronic device having the filter or the resonator assembly.

### BACKGROUND

A bulk acoustic wave filter has the advantages of low insertion loss, high rectangular coefficient, high power capacity and the like, and thus is widely applied to the current wireless communication system and is an important component for determining the quality of a radiofrequency signal entering and exiting the communication system.

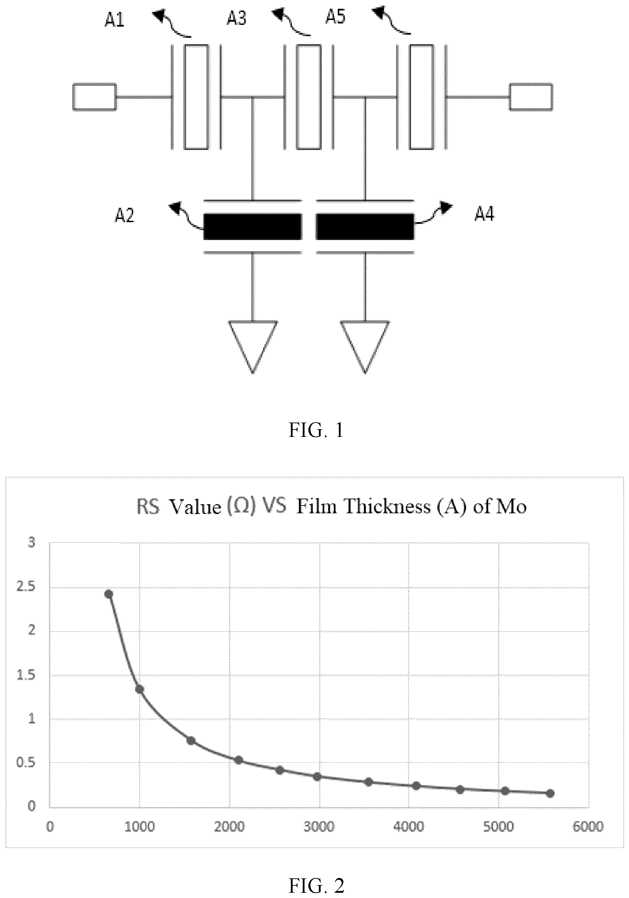

FIG. 1 is a schematic diagram of a common trapezoidal structure of a filter, in which a plurality of series resonators and a plurality of parallel resonators are illustrated. As 5G requires higher and higher filter frequencies, the film thickness of a bulk acoustic resonator becomes thinner and thinner. As shown in FIG. 2, the electrode resistance is remarkably increased due to a decreased electrode thickness, resulting in an increased insertion loss of the filter. In addition, the 5G frequency band generally has higher bandwidth requirements for the filter than the 4G frequency band, thereby requiring the resonator to have a higher electromechanical coupling coefficient. Under this requirement, the thickness of the piezoelectric material has to be increased in order to increase the electromechanical coupling coefficient of the resonator, and meanwhile, the electrode thickness has to be decreased in order to maintain the resonant frequency of the resonator unchanged, thereby resulting in a further increase in the electrode resistance.

A conductive layer or a conductive protruding structure electrically connected to a top electrode is provided between the top electrode and a piezoelectric layer, such that the resistance of the top electrode of the resonator can be reduced. However, the thickness of the conductive layer or the conductive protruding structure also affects the series impedance Rs and the parallel impedance Rp of the resonator. For the filter, the performance of the series resonators and the parallel resonators affects the insertion loss of a passband of the filter. Accordingly, in order to reduce the insertion loss of the passband of the filter, it is required that the series impedance Rs of the series resonators is relatively small, and the parallel impedance Rp of the parallel resonators is relatively large.

However, in the existing filter, the conductive layers or conductive protruding structures of the series resonators and the parallel resonators have the same thickness, which is not conducive to further reducing the insertion loss of the passband of the filter.

### SUMMARY

In order to solve at least one aspect of the above technical problems in the related art, the present disclosure provides a new structural solution to reduce insertion loss of a passband of a filter to further improve the performance of the filter.

According to one aspect of embodiments of the present disclosure, a filter is provided and includes a plurality of series resonators and a plurality of parallel resonators. Each of the plurality of series resonator and the plurality of parallel resonators includes a substrate, an acoustic mirror, a bottom electrode, a top electrode, and a piezoelectric layer. The top electrode of at least one series resonator of the plurality of series resonators and the top electrode of at least one parallel resonator of the plurality of parallel resonators have or are provided with protrusion portions at both top electrode connection ends and non-top electrode connection ends, and a top surface of each of the protrusion portions is higher than a top surface of an inner side portion of the top electrode. The resonators having the protrusion portions each include a conductive layer, the conductive layer is in contact with a corresponding electrode of the top electrode and the bottom electrode of the resonator in a thickness direction of the resonator, and the conductive layer is configured in such a manner that the protrusion portion is higher than the top surface of the inner side portion of the top electrode. The conductive layer of the at least one series resonator has a thickness greater than a thickness of the conductive layer of the at least one parallel resonator.

The embodiments of the present disclosure further relate to a bulk acoustic wave resonator assembly. The bulk acoustic wave resonator assembly includes a first resonator and a second resonator, both of which are bulk acoustic wave resonators. Each of the first resonator and the second resonator includes a substrate, an acoustic mirror, a bottom electrode, a top electrode, and a piezoelectric layer, the top electrodes of the first resonator and the second resonator are connected to each other or the bottom electrodes of the first resonator and the second resonator are connected to each other. The top electrodes of the first resonator and the second resonator have or are provided with protrusion portions at both top electrode connection ends and non-top electrode connection ends, and a top surface of each of the protrusion portions is higher than a top surface of an inner side portion of the top electrode. The first resonator and the second resonator each include a conductive layer, which is in contact with a corresponding electrode in a thickness direction of the resonator, and the conductive layer is configured in such a manner that the protrusion portion is higher than the top surface of the inner side portion of the top electrode. The conductive layer of the first resonator has a thickness different from a thickness of the conductive layer of the second resonator.

The embodiments of the present disclosure further relate to a method of manufacturing the above bulk acoustic wave resonator assembly, wherein the thickness of the conductive layer of the first resonator is greater than that of the conductive layer of the second resonator. The method includes: depositing a first deposition layer in a region where the first resonator and the second resonator are located; depositing a second deposition layer in a region corresponding to the first resonator on the first deposition layer; and patterning the first deposition layer and the second deposition layer to form the conductive layer of the first resonator and the conductive layer of the second resonator, the thickness of the conductive layer of the first resonator being the sum of a thickness of the first deposition layer and a thickness of the second deposition layer, and the thickness of the conductive layer of the second resonator being the thickness of the first deposition layer.

The embodiments of the present disclosure further relate to an electronic device including the above filter or resonator assembly.

### BRIEF DESCRIPTION OF DRAWINGS

The following description and drawings may facilitate to understand these and other features and advantages in various embodiments of the present disclosure. The same reference signs in the drawings always indicate the same components.
FIG. 1 is a schematic structural diagram of a filter, in which a plurality of series resonators and a plurality of parallel resonators are shown.
FIG. 2 is a graph showing a relationship between a thickness of an electrode or electrode film and square resistance of the electrode film.
FIG. 3 is an example diagram showing a relationship between a series impedance Rs of a bulk acoustic wave resonator and a thickness of a protruding structure.
FIG. 4 is an example diagram showing a relationship between a parallel impedance Rp of the bulk acoustic wave resonator and the thickness of the protruding structure.
FIG. 5 is a schematic sectional view of a series resonator and a parallel resonator, which are adjacent to each other, of a filter according to an exemplary embodiment of the present disclosure, in which the two resonators share a top electrode or top electrodes of the two resonators are connected to each other.
FIG. 6 is a schematic sectional view of two adjacent series resonators of a filter according to an exemplary embodiment of the present disclosure, in which the two resonators share a top electrode or top electrodes of the two resonators are connected to each other.
FIG. 7 is a schematic sectional view of two adjacent series resonators of a filter according to an exemplary embodiment of the present disclosure, in which the two resonators share a bottom electrode or bottom electrodes of the two resonators share are connected to each other.
FIG. 8 exemplarily illustrates a graph of passband insertion loss of a filter, in which a curve where m1 is located corresponds to a protruding structure of the series resonator of the filter with a thickness of 1000 Å and a protruding structure of the parallel resonator of the filter with a thickness of 400 Å, and a curve where m2 is located corresponds to protruding structures of the series resonator and the parallel resonator of the filter with a thickness of 400 Å.
FIGS. 9-18 exemplarily illustrate manufacturing steps for manufacturing the structure shown in FIG. 5 according to an exemplary embodiment of the present disclosure.
FIG. 19 is a top view of a resonator of a filter according to an embodiment of the present disclosure.
FIG. 20 is a schematic sectional view along line A1-A1 in FIG. 19.
FIG. 21 exemplarily illustrates a cross-sectional view of a conductive layer in FIG. 20.
FIG. 22 is a graph showing change of a parallel impedance (Rp) of a resonator with a conventional protruding structure and a width W of the protruding structure.

### DESCRIPTION OF EMBODIMENTS

The technical solutions of the present disclosure will be further described below in detail through embodiments and in conjunction with the drawings. The same or similar reference signs indicate the same or similar components throughout the description. The following description of embodiments of the present disclosure with reference to the drawings is intended to explain the general inventive concept of the present disclosure, and should not be construed as a limitation to the present disclosure.

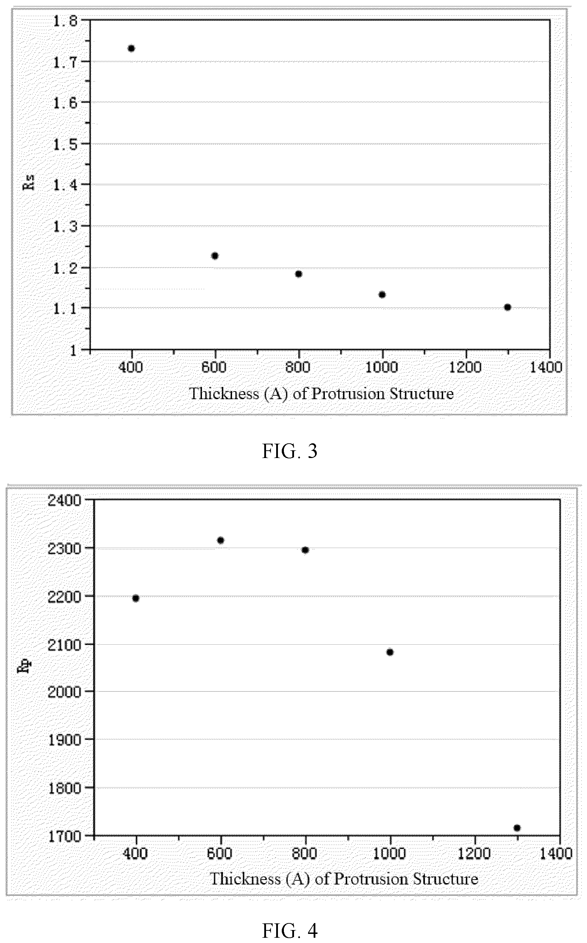

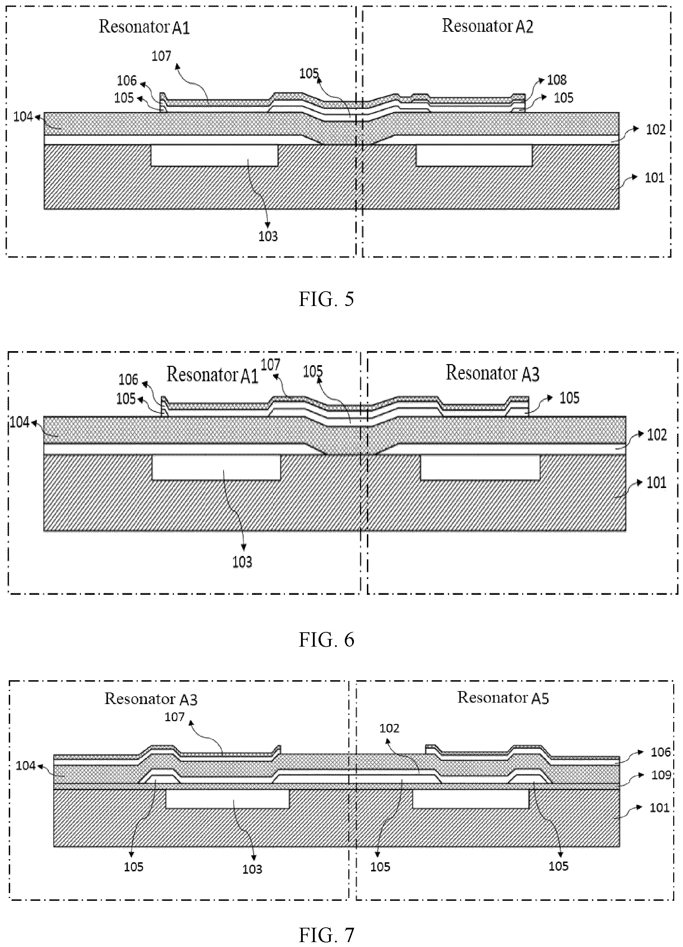

FIG. 3 is an example diagram showing a relationship between a series impedance Rs of a bulk acoustic wave resonator and a thickness of a protruding structure, and FIG. 4 is an example diagram showing a relationship between a parallel impedance Rp of the bulk acoustic wave resonator and the thickness of the protruding structure. In this embodiment, an electrode has a thickness of 1000 Å. As shown in FIG. 3, the series impedance Rs of the resonator decreases as the thickness of the protruding structure (indicated by 105 in FIG. 5) increases. In addition, as shown in FIG. 4, the parallel impedance Rp of the resonator first increases and then decreases along with the thickness of the protruding structure. In general, it is preferable that the thickness of the protruding structure is less than that of an electrode in contact with the protruding structure. Therefore, when the serial and parallel protruding structures of the filter have the same thickness, it is impossible to configure the series impedance Rs of the series resonator to be low and meanwhile configure the parallel impedance Rp of the parallel resonator to be at a preferable value.

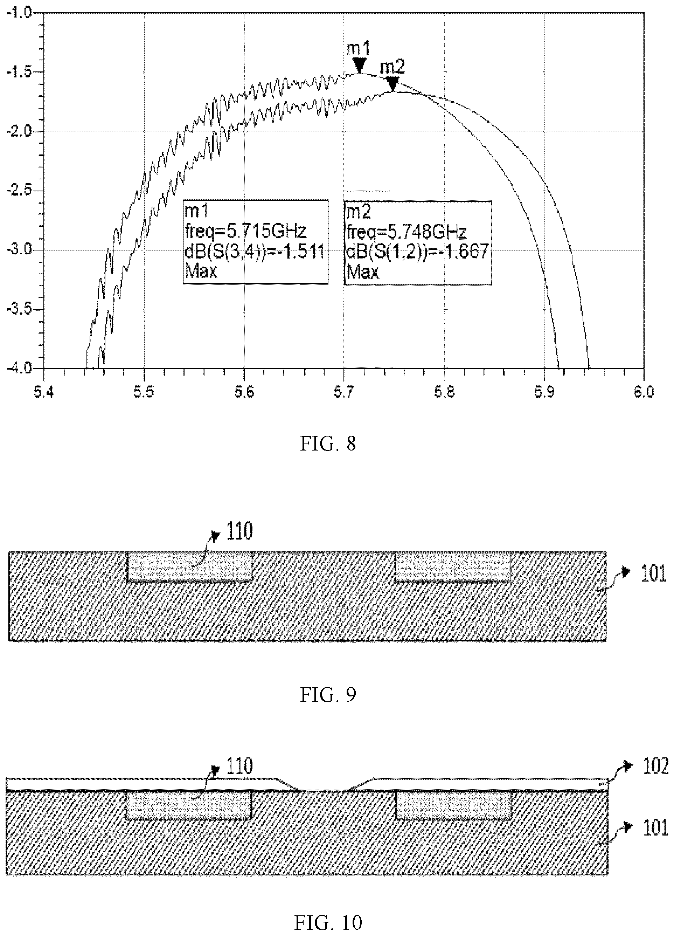

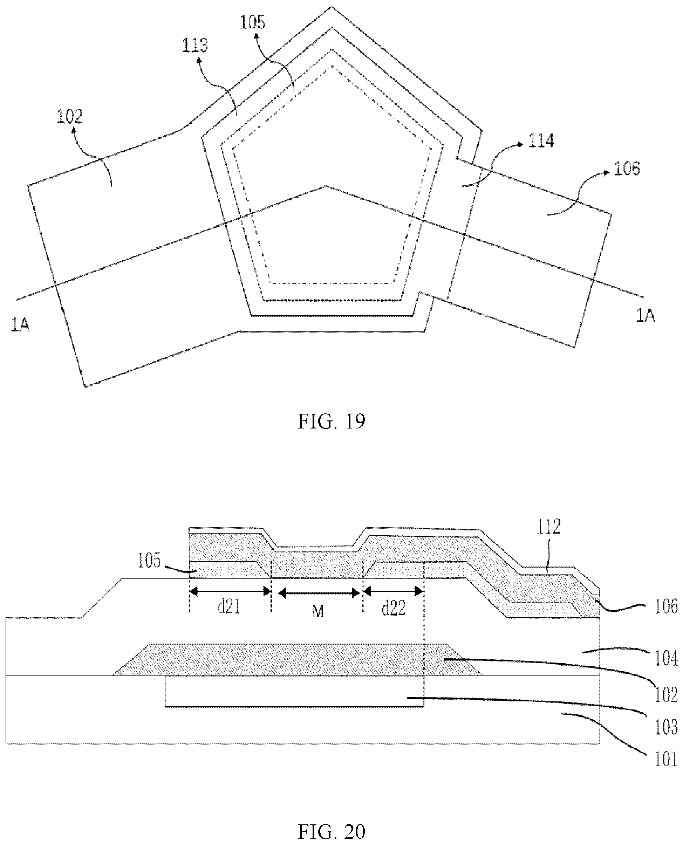

FIG. 8 exemplarily illustrates a graph showing a passband insertion loss curve of a filter, in which a curve where m1 is located corresponds to a protruding structure of the series resonator of the filter with a thickness of 1000 Å and a protruding structure of the parallel resonator of the filter with a thickness of 400 Å, and a curve where m2 is located corresponds to protruding structures of the series resonator and the parallel resonator of the filter with a thickness of 400 Å. In this embodiment, the thickness of the electrode is 1000 Å. As can be seen from FIG. 3 and FIG. 4, when the thickness of the protruding structure is 1000 Å, the series impedance Rs is about 1.15 Ω, and the parallel impedance Rp is about 2100 Ω. When the thickness of the protruding structure is 400 Å, the series impedance Rs is about 1.75 Ω and the parallel impedance Rp is about 2200 Ω. Compared with the resonator in which the thickness of the protruding structure is 1000 Å, the series impedance Rs is decreased, but the parallel impedance Rp is improved. In the filter of a conventional trapezoidal structure (as shown in FIG. 1), the series impedance Rs of the series resonator and the parallel impedance Rp of the parallel resonator mainly affect the insertion loss (referred to as insertion loss) near the center frequency of the passband of the filter, the parallel impedance Rp of the series resonator mainly affects the insertion loss of a right edge of the filter, and the series impedance Rs of the parallel resonator mainly affects the insertion loss of a left edge of the filter. Therefore, the lower the series impedance Rs of the series resonator is, the higher the parallel impedance Rp of the parallel resonator is, and the better the insertion loss near the center frequency of the filter is. When the parallel impedance Rp of the series resonator decreases, the insertion loss at the right edge of the filter deteriorates. However, the insertion loss at the right edge of the filter can be improved by appropriately increasing the electromechanical coupling coefficient of the resonator. Similarly, when the series impedance Rs of the parallel resonator decreases, the insertion loss of the left edge of the filter deteriorates, but can be adjusted by appropriately increasing the electromechanical coupling coefficient of the resonator. As can be seen from FIG. 8, compared with the curve where m2 is located, the position of the highest point of the insertion loss of the passband for the curve where m1 is located can be increased by about 0.15 dB (increased from -1.667 dB to -1.511 dB). Further, as can be seen from FIG. 3 and FIG. 4, if a protruding structure with a thickness of 600 Å is provided in the parallel resonator, compared with the resonator in which the thickness of the protruding structure is 400 Å, the parallel impedance Rp thereof can be further increased to 2300 Ω and the series impedance Rs can be further reduced to 1.25 Ω. In this way, the insertion loss at the left side and the center of the filter can be further improved. If combined with the method for adjusting the electromechanical coupling coefficient in subsequent FIGS. 19-21 (but is not limited to this method), the electromechanical coupling coefficient is further optimized, thereby improving the overall performance of the passband of the filter.

Based on the above description, the present disclosure provides a filter. The thickness of a protruding structure of a series resonator of the filter is greater than the thickness of a protruding structure of a parallel resonator. Accordingly, the thicknesses of the protruding structures of the series resonator and the parallel resonator can be further optimized to reduce the insertion loss of the passband of the filter.

The structures of the series resonator and the parallel resonator in the filter are exemplarily illustrated below with reference to FIG. 5. FIG. 5 is a schematic sectional view of a series resonator and a parallel resonator, which are adjacent to each other, of a filter according to an exemplary embodiment of the present disclosure.

In the present disclosure, the reference signs are exemplarily described as follows:
101: a substrate, which may be made of monocrystalline silicon, quartz, silicon carbide, gallium nitride, gallium arsenide, sapphire, diamond or the like;
102: a bottom electrode (including an electrode pin), which may be made of molybdenum, ruthenium, gold, aluminum, magnesium, tungsten, copper, titanium, iridium, osmium or chromium, or a compound or an alloy thereof;
103: an acoustic mirror, which is of an air cavity structure in the present embodiment, or may be a Bragg reflection layer or other equivalent acoustic wave reflection structures;
104: a piezoelectric film layer or a piezoelectric layer, which may be made of aluminum nitride, zinc oxide, PZT, or the like, and may contain rare earth element doped materials with a certain atomic ratio of the above materials;
105: a protruding structure, which may be made of molybdenum, ruthenium, gold, aluminum, magnesium, tungsten, copper, titanium, iridium, osmium or chromium, or a compound or an alloy thereof;
106: a top electrode (including an electrode pin), which may be made of molybdenum, ruthenium, gold, aluminum, magnesium, tungsten, copper, titanium, iridium, osmium or chromium, or a compound or an alloy thereof;
107: a passivation layer, which is generally made of a medium material, such as silicon dioxide, aluminum nitride, and silicon nitride;
108: a mass load, which has the same selectable material range as the electrode or protruding structure;
109: an etching barrier layer, which may be made of aluminum nitride or the like;
110: a sacrificial layer, which may be made of silicon dioxide, doped silicon dioxide, or the like;
111: photoresist;
113: a wing structure; and
114: abridge structure.

As shown in FIG. 5, a left resonator is a series resonator, a right resonator is a parallel resonator, and the two resonators are connected by a top electrode. In this example, the thickness of the protruding structure 105 of the series resonator is greater than that of the protruding structure 105 of the parallel resonator. In a further embodiment, a total thickness of the top electrode and the protruding structure 105 of the series resonator is greater than 2000 Å, and the thickness of the protruding structure of the parallel resonator is less than that of the top electrode. In an optional embodiment, when the resonator has a mass load, the aforementioned electrode thickness may be considered to be the total thickness of the electrode thickness and the thickness of the mass load. In addition, as can be seen from FIG. 5, the protruding structure 105 of the series resonator extends from an effective region of the resonator A1 to the outer side of the resonator. The protruding structure 105 covers at least 50% of a top electrode connection region, and further covers more than 80% of the top electrode connection region. The top electrode connection region refers to a top electrode connection portion beyond the effective regions of the series resonator A1 and the parallel resonator A2. Such an extension of the protruding structure of the series resonator can thicken the top electrode connection portion, and the total thickness thereof is greater than 2000 Å. In this way, the electrical loss of the passband of the filter can be further reduced, so that the insertion loss thereof is superior. At the same time, heat generated during the operation of the resonator is conducted outwards, thereby improving the power capacity of the filter.

FIG. 6 is a schematic sectional view of two adjacent series resonators of a filter according to an exemplary embodiment of the present disclosure. In FIG. 6, the two resonators are both series resonators and connected by a top electrode. In a further embodiment, a total thickness of the top electrode 106 and the protruding structures 105 of the two series resonators is greater than 2000 Å. Similarly, as can be seen from FIG. 6, the protruding structures 105 of the two series resonators extend outwards to completely cover a top electrode connection region between the resonators.

FIG. 7 is a schematic sectional view of two adjacent series resonators of a filter according to an exemplary embodiment of the present disclosure, in which the two resonators share a bottom electrode or bottom electrodes of the two resonators are connected to each other. In FIG. 7, the two resonators are both series resonators, and the two resonators are connected by the bottom electrode. In the example shown in FIG. 7, the protruding structure 105 is arranged below the bottom electrode 102. In a further embodiment, the total thickness of the protruding structures 105 and the bottom electrodes 102 of the series resonators is greater than 2000 Å. Similarly, in FIG. 7, the protruding structures 105 of the two series resonators extend outwards to completely cover a bottom electrode connection region between the resonators.

Although not shown, in an optional embodiment, the series resonator and the parallel resonator of the filter, which are adj acent to each other, may be connected to each other through the bottom electrodes. Accordingly, conductive layers of the series resonator and the parallel resonator, which are adjacent to each other, are arranged below piezoelectric layers and are in contact with the bottom electrodes. In the present disclosure, located below the piezoelectric layer includes located between the piezoelectric layer and the bottom electrode or between the bottom electrode and the substrate, which are all within the scope of the present disclosure.

In FIG. 5 and subsequent FIGS. 6-7, the top electrode of the series resonator and the top electrode of the parallel resonator are provided with protrusion portions (corresponding to regions indicated by d21 and d22 in FIG. 20 described below) at both a top electrode connection end and a non-top electrode connection end, and top surfaces of the protrusion portions are higher than a top surface of an inner side portion (corresponding to a region indicated by M in FIG. 20 described below) of the top electrode. The resonator having the protrusion portions includes a conductive layer (corresponding to the protruding structure 105), which is located below the top electrode. The conductive layer enables the protrusion portions to be higher than the top surface of the inner side portion M of the top electrode. A further description is given below with reference to FIGS. 19-21.

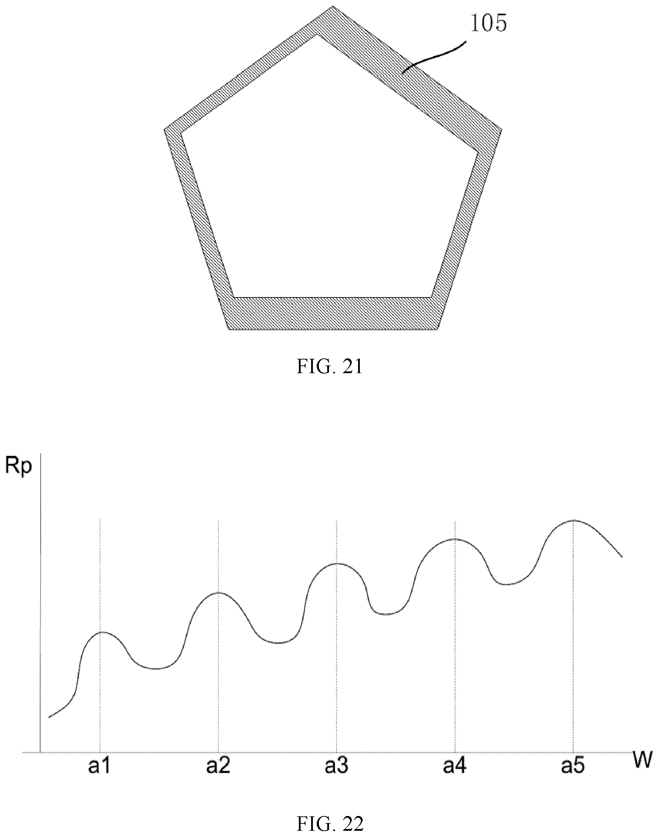

FIG. 19 is a top view of a resonator of a filter according to an embodiment of the present disclosure. FIG. 20 is a schematic sectional view along line A1-A1 in FIG. 19. FIG. 21 exemplarily illustrates a cross-sectional view of the conductive layer in FIG. 20.

In FIG. 19, the effective region of the resonator is a convex pentagonal structure. The present disclosure is not limited thereto, and the effective region may be other convex polygonal structures.

The protruding structure 105 has different widths on different edges of the pentagon structure. As indicated by d21 and d22 in FIG. 20, in the present disclosure, a width of an edge is a width within a boundary of an acoustic mirror along a lateral or radial direction of the resonator, that is, the protruding structure has different widths on each edge of the pentagon structure. The difference in width herein means that a width of at least one edge is different from widths of the remaining edges. The electromechanical coupling coefficient of the resonator can be adjusted by changing the widths of the protruding structure 105 at each edge and the proportion of each width to the five edges (i.e., by changing a ratio of the number of width edges to a total number of edges of a polygon). At the same time, the presence of the protruding structure on each edge allows the parallel impedance Rp (or a quality factor Qp) at a parallel resonance frequency at a higher level without a significant drop due to the adjustment of the width of the protruding structure on each edge.

As shown in FIG. 20, due to the presence of the protruding structure 105, the top electrode 106 is provided with protrusion portions at both a top electrode connection end (at right side in FIG. 20) and a non-top electrode connection end (at left side in FIG. 20). It is apparent that the protrusion portion includes the wing structure 113 and a part of the bridge structure 114 in FIG. 20. In FIG. 20, the top surface of the protrusion portion is higher than the top surface of the inner side portion M of the top electrode. As shown in FIG. 19, the inner side portion M of the top electrode is a convex polygonal region with five edges, the protrusion portions are arranged around the convex polygonal region to form a polygonal electrode frame. In FIG. 20, the electrode frame is composed of the wing structure 113 and the bridge structure 114 that is located on the inner side of the acoustic mirror, and the electrode frame includes a plurality of frame edges.

When the pentagonal protruding structures of the resonator have the same width, the widths of the protruding structures have a corresponding relationship with the electromechanical coupling coefficient kt² of the resonator. For example, when the widths of the protruding structures on the five edges of the resonator are all 2 µm, the corresponding kt² is 8.0%, and when the widths of the protruding structures on the five edges of the resonator are all 5 µm, the corresponding kt² is 7.5%. In general, the electromechanical coupling coefficients of resonators with the same area decrease as the widths of the protruding structures increase.

In the present disclosure, the frame edges of the electrode frame of the resonator have different widths. When the width of the electrode frame is consistent with that of the protruding structure, i.e., an inner side starting point is consistent with an outer side ending point, the width of the electrode frame is determined by the widths of the protruding structure 105. In an embodiment, as shown in FIG. 20 and FIG. 21, the protruding structure has different widths on the five edges of the protruding structure 105, the kt² of the resonator may be adjusted, while other properties (e.g., a Q value at a frequency of the parallel resonator) are substantially unaffected. Further, kt² may be further adjusted by selecting the number of edges of the protruding structure with the same width. For example, when the widths of five edges of the protruding structure are all 2 µm, kt² is 8.0%; when the widths of four edges of the protruding structure are all 2 µm and the width of the other edge is 5 µm, kt² is 7.9%; when the widths of three edges of the protruding structure are all 2 µm and the widths of the other two edges are 5 µm, kt² is 7.8%; when the widths of two edges of the protruding structure are both 2 µm and the widths of the other three edges are 5 µm, kt² is 7.7%; when the width of one edge of the protruding structure is 2 µm and the widths of the other four edges are 5 µm, kt² is 7.6%; and when the widths of five edges of the protruding structure are all 5 µm, kt² is 7.5%.

FIG. 22 is a graph showing change of a parallel impedance Rp of a resonator with a conventional protruding structure and a width W of the protruding structure. The traditional protruding structure refers to a case where the widths of the protruding structure at all edges of one resonator are the same. As shown in FIG. 22, the value of the parallel impedance Rp exhibits periodic characteristics with the increase in the width W, and each period has a peak point. As shown in FIG. 22, the widths such as a1, a2, a3, a4, a5 of the protruding structure corresponding to local peak values approximately satisfy a proportional relationship a1: a2: a3: a4: a5:... = 1: 3: 5: 7: 9:..... Moreover, the electromechanical coupling coefficient monotonically decreases along with the increase in the widths of the protruding structure. In one resonator, therefore, in order to adjust kt² and ensure that the value of the parallel impedance Rp substantially remains unchanged, the widths of the protruding structure corresponding to the peak values in different periods may be combined. As described above, the width of the protruding structure corresponding to the peak value of the first period is 2 µm and the width of the protruding structure corresponding to the peak value of the second period is 5 µm, such that the protruding structures with these two widths are combined in one resonator. Accordingly, the parallel impedance Rp can be maintained at a peak value level by adjusting kt².

Since a filter has a specific frequency and bandwidth, the resonator constituting the filter can meet this requirement by setting specific thicknesses of the bottom electrode, the piezoelectric layer, and the top electrode. After the thickness of the protruding structure and the widths corresponding to the peak values are determined, the electromechanical coupling coefficient of the resonator is substantially determined. However, in an actual design process of the filter, in order to achieve excellent performance, the electromechanical coupling coefficient of the resonator needs to be adjusted within a small range. In the present disclosure, on the premise not increasing the process difficulty and not significantly affecting the series impedance Rs and the parallel impedance RP of the resonator, the electromechanical coupling coefficient is adjustable in a certain range by providing different protruding structures on each edge of the resonator and the wing and bridge structures with different widths. For example, the electromechanical coupling coefficient is flexibly adjusted by selecting the widths of two or more protruding structures, bridge structures or wing structures on different edges of the resonator and controlling the proportion of each width to the five edges. Therefore, the overall insertion loss performance of the passband of the filter is further improved by adjusting the thicknesses of the protruding structures on the series resonators and the parallel resonators.

In the embodiments shown in FIGS. 19-21, the protruding structure 105 is a conductive layer located between the top electrode and the piezoelectric layer. The conductive layer is arranged between the top electrode 106 and the piezoelectric layer 104. The protrusion portion includes a bridge portion or bridge structure 114 located at the top electrode connection end and a wing structure 113 located at the non-top electrode connection end. The conductive layer includes an insertion frame (corresponding to the protruding structure 105 in FIG. 21) located in the acoustic mirror in the lateral direction, and the insertion frame and the electrode frame have the same inner side boundary and the same outer side boundary in the lateral direction.

In the embodiment shown in FIGS. 19-21, the frames have different widths. However, the present disclosure is not limited thereto, and the width of a single frame may change in a longitudinal direction thereof.

FIG. 5 also shows a bulk acoustic wave resonator assembly having two resonators, wherein each of the two resonators includes a conductive layer in contact with a corresponding electrode in a thickness direction of the resonator. The conductive layer enables the protrusion portion to be higher than the top surface of the inner side portion of the top electrode, and the thickness of the conductive layer of one resonator is different from that of the conductive layer of the other resonator.

The manufacturing method of the structure shown in FIG. 5 is exemplarily described below with reference to FIGS. 9-18. In the description with reference to FIGS. 9-18, the protruding structure 105 is divided into two layers. Alternatively, in the embodiments shown in FIGS. 5-7, structures of the two layers of protruding structures are not distinguished.

As shown in FIG. 9, after a cavity structure is formed on the substrate 101, a sacrificial material is filled, and then the sacrificial material is ground by a CMP (chemical mechanical polishing) process. As shown in FIG. 9, the substrate 101 is provided with two cavity structures, which are spaced apart from each other.

As shown in FIG. 10, a metal layer is deposited on the surface of the substrate 101, and the metal layer is patterned into the bottom electrode 102. Although not shown, a seed layer may be deposited on the substrate, and the metal layer is then deposited and patterned on the seed layer to form the bottom electrode 102. As shown in FIG. 10, the bottom electrodes corresponding to the two resonators are spaced apart from each other.

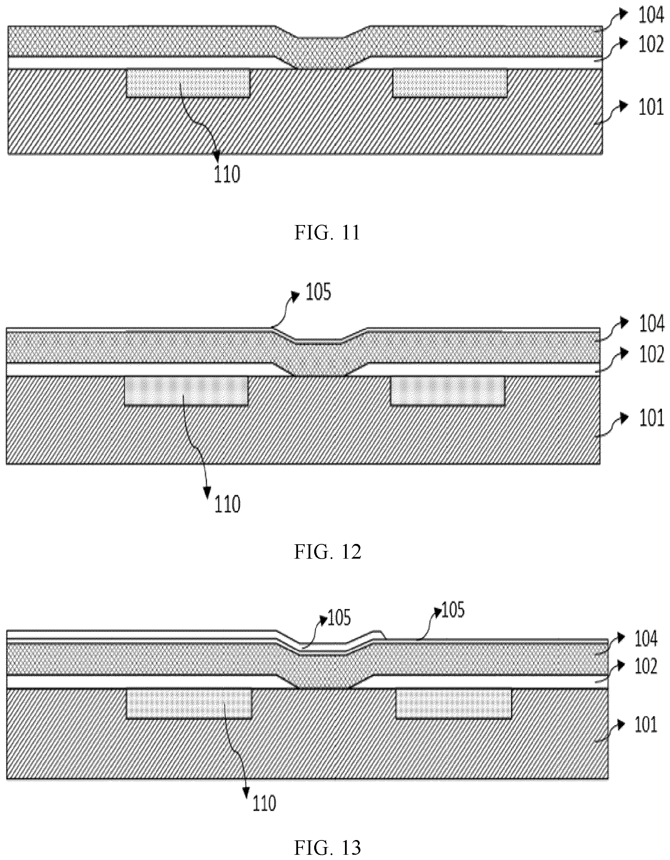

As shown in FIG. 11, the piezoelectric thin film layer 104 is deposited on the surface of the structure shown in FIG. 10, such as aluminum nitride (AlN) and gallium nitride (GaN). The used deposition process includes, but is not limited to, MOCVD (Metal Organic Chemical Vapor Deposition), MBE (Molecular Beam Epitaxy), CBE (Chemical Molecular Beam Epitaxy), and LPE (Liquid Phase Epitaxy). As shown in FIG. 11, the piezoelectric film layer 104 covers the two bottom electrodes corresponding to the resonators.

As shown in FIG. 12, a first layer of protruding structure material is deposited on the surface of the piezoelectric thin film layer 104 by a thin film deposition process, and the first layer of protruding structure material covers corresponding regions of the series resonator and the parallel resonator. In a specific embodiment, the thickness of the first layer of protruding structure material is equal to that of the conductive layer or the protruding structure of the parallel resonator, and further, the thickness thereof is less than that of the top electrode.

As shown in FIG. 13 on the basis of the structure shown in FIG. 12, a second layer of protruding structure material is selectively deposited in a region where the series resonator is located by the thin film deposition process. Therefore, in the region corresponding to the series resonator, the thickness of the material for forming the protruding structure is greater than that of the protruding structure corresponding to the region of the parallel resonator. In a further embodiment, the sum of the total thickness of the two layers of protruding structure materials and the thickness of the top electrode is greater than 2000 Å. The second layer of protruding structure material may be formed by a lift-off process.

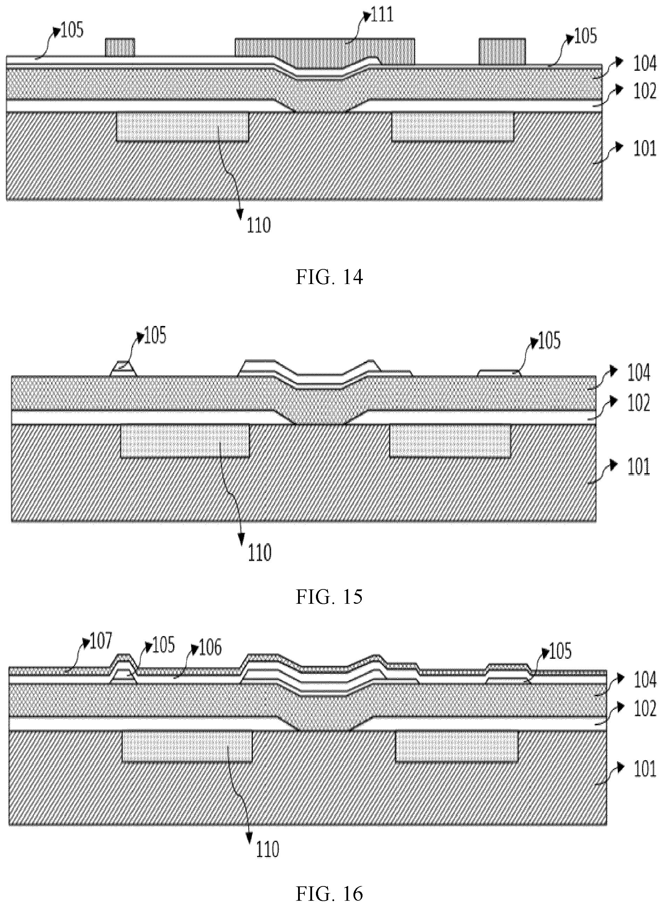

As shown in FIG. 14, firstly, the photoresist 111 is sequentially coated on the structure shown in FIG. 13, then patterning exposure is performed on the photoresist 111. After that, the exposed photoresist is removed by developing to form a required pattern of the protruding structure, and the pattern of the photoresist corresponds to the pattern of the protruding structure, as shown in FIG. 14.

The second layer of protruding structure material is deposited in the region corresponding to the series resonator on the first layer of protruding structure material. The above situation includes that the second layer of protruding structure material covers only the region corresponding to the series resonator and the second layer of protruding structure material further covers the top electrode connection region between the series resonator and the parallel resonator, which are all within the scope of the present disclosure.

As shown in FIG. 15, an etching process is performed on the structure in FIG. 14, and the remaining photoresist is then stripped off, so as to form the protruding structure shown in FIG. 15. In FIG. 15, it can be seen that the protruding structure on the left side has a two-layer structure with a larger thickness, and the protruding structure on the right side has a single-layer structure with a smaller thickness.

As shown in FIG. 16, the top electrode 106 and a passivation layer 107 are sequentially deposited on the structure shown in FIG. 15 by the thin film deposition process. In the structure shown in FIG. 16, the top electrodes of the two resonators are connected to each other.

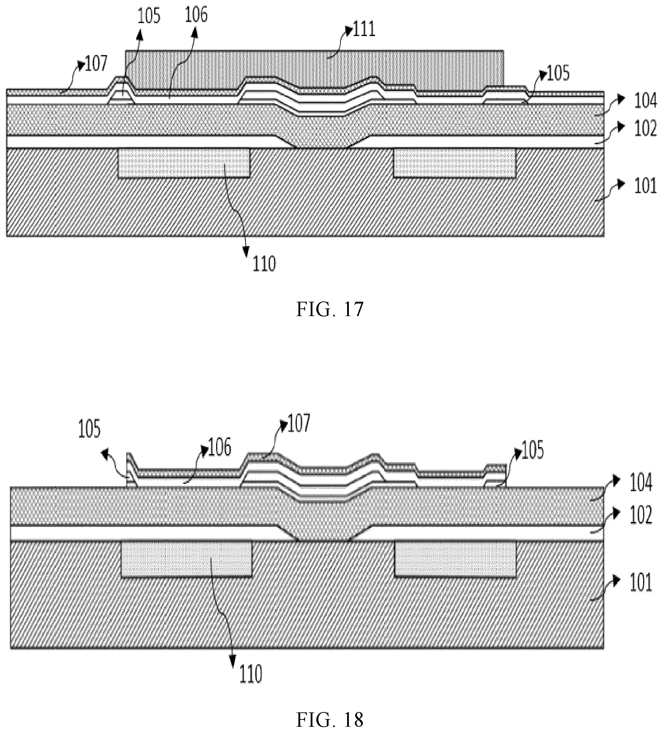

As shown in FIG. 17, firstly, the photoresist 111 is sequentially coated on the structure shown in FIG. 16, and patterning exposure is then performed on the photoresist 111. After that, the exposed photoresist is removed by developing to form a required pattern of the protruding structure, and the pattern of the photoresist in FIG. 17 corresponds to the pattern of the protruding structure.

As shown in FIG. 18, the etching process is performed on the passivation layer and the top electrode in the structure of FIG. 17, and the remaining photoresist is then stripped off, so as to form a top electrode pattern and a passivation layer pattern shown in FIG. 18.

Finally, an etchant is introduced through a release hole (not shown) to release the sacrificial layer in the cavity structure, to obtain the structure corresponding to FIG. 5.

In the illustrated embodiments of the present disclosure, the conductive layer is an insertion layer, that is, the conductive layer is located below the top electrode. However, the conductive layer may be arranged on an upper surface of the top electrode to be in contact with the top electrode. In this case, the conductive layer forms the above protrusion portion, and these also fall within the scope of the present disclosure.

Based on the above description, the present disclosure provides the following technical solutions.
1. A filter includes:
   a plurality of series resonators; and
   a plurality of parallel resonators,
   wherein:
      each of the plurality of series resonator and the plurality of parallel resonators includes a substrate, an acoustic mirror, a bottom electrode, a top electrode, and a piezoelectric layer;
      the top electrode of at least one series resonator of the plurality of series resonators and the top electrode of at least one parallel resonator of the plurality of parallel resonators have or are provided with protrusion portions at both top electrode connection ends and non-top electrode connection ends, and a top surface of each of the protrusion portions is higher than a top surface of an inner side portion of the top electrode;
      the resonators having the protrusion portions each include a conductive layer, the conductive layer is in contact with a corresponding electrode of the top electrode and the bottom electrode of the resonator in a thickness direction of the resonator, and the conductive layer is configured in such a manner that the protrusion portion is higher than the top surface of the inner side portion of the top electrode; and
      the conductive layer of the at least one series resonator has a thickness greater than a thickness of the conductive layer of the at least one parallel resonator.
2. The filter according to 1, wherein:
   the thickness of the conductive layer of the at least one parallel resonator having the protrusion portions is less than a thickness of the corresponding electrode in contact therewith.
3. The filter according to 2, wherein:
   the thickness of the conductive layer of the at least one parallel resonator having the protrusion portions is greater than the thickness of the corresponding electrode in contact therewith; or
   the sum of the thickness of the conductive layer of the at least one series resonator having the protrusion portions and the thickness of the corresponding electrode in contact therewith is equal to or greater than 2000 Å.
4. The filter according to 3, wherein:
   the conductive layer of the resonator having the protrusion portions is arranged between an upper surface of the piezoelectric layer and a lower surface of the top electrode.
5. The filter according to 4, wherein:
   the top electrode of the resonator having the protrusion portions is provided with a conductive mass load layer, the conductive layer is in contact with the top electrode, and a thickness of the top electrode is the sum of the thickness of the top electrode and the thickness of the mass load layer.
6. The filter according to 3, wherein:
   the conductive layer of the resonator having the protrusion portions is arranged below the piezoelectric layer and is in contact with the bottom electrode.
7. The filter according to 1, wherein:
   the inner side portion is a convex polygonal region having a plurality of edges, the protrusion portions are arranged around the convex polygonal region to form a polygonal electrode frame, and the electrode frame includes a plurality of frame edges.
8. The filter according to 7, wherein:
   the plurality of frame edges of the electrode frame has different lateral widths in the acoustic mirror.
9. The filter according to 8, wherein:
   the lateral width of at least one of the plurality of frame edges of the electrode frame in the acoustic mirror is different from the lateral width of at least one of the remaining frame edges of the plurality of frame edges in the acoustic mirror.
10. The filter according to 1, wherein:
   the conductive layers of adjacent resonators are conductive layers arranged in the same layer.
11. The filter according to any one of 1-10, wherein:
   at least two adjacent resonators of the filter are the resonators having the protrusion portions.
12. The filter according to 11, wherein:
   the filter includes a parallel resonator and a series resonator that are adjacent to each other, the top electrode of the parallel resonator is connected with the top electrode of the series resonator, and the conductive layers of the parallel resonator and the series resonator that are adjacent to each other are arranged between the top electrode and the piezoelectric layer; or
   the filter includes a parallel resonator and a series resonator that are adjacent to each other, the top electrode of the parallel resonator is connected with the top electrode of the series resonator, the conductive layers of the parallel resonator and the series resonator that are adjacent to each other are arranged on an upper surface of the top electrode, and the conductive layers form the protrusion portions.
13. The filter according to 11, wherein:
   the filter includes adjacent series resonators of which the top electrodes are connected to each other, and each of the conductive layers of the adjacent series resonators is arranged between the top electrode and the piezoelectric layer; or
   the filter includes adjacent series resonators of which the top electrodes are connected to each other, each of the conductive layers of the adjacent series resonators is arranged on the upper surface of the top electrode, and the conductive layer forms the protrusion portion.
14. The filter according to 11, wherein:
   the filter includes adjacent series resonators of which the bottom electrodes are connected to each other, and each of the conductive layers of the adjacent series resonator is arranged below the piezoelectric layer and is in contact with the bottom electrode; or
   the filter includes a series resonator and a parallel resonator that are adjacent to each other, the bottom electrode of the series resonator is connected with the bottom electrode of the parallel resonator, and each of the conductive layers of the series resonator and the parallel resonator that are adjacent to each other is arranged below the piezoelectric layer and is in contact with the bottom electrode.
15. The filter according to 12, wherein:
   in the parallel resonator and series resonator that are adjacent to each other, in an electrode connection region between the parallel resonator and series resonator, the conducive layer of the series resonator is connected to the conducive layer of the parallel resonator on an outer side of an effective region of the parallel resonator.
16. The filter according to 15, wherein:
   the conductive layer of the series resonator extends across at least 50% of an area of the electrode connection region.
17. The filter according to 13, wherein:
   in the adjacent series resonators, the conductive layers of the series resonators extend across the entire electrode connection region between the adjacent series resonators.
18. A bulk wave acoustic resonator assembly includes:
   a first resonator and a second resonator, both of which are bulk acoustic wave resonators, each of the first resonator and the second resonator including a substrate, an acoustic mirror, a bottom electrode, a top electrode, and a piezoelectric layer, the top electrodes of the first resonator and the second resonator being connected to each other or the bottom electrodes of the first resonator and the second resonator being connected to each other;
   the top electrodes of the first resonator and the second resonator have or are provided with protrusion portions at both top electrode connection ends and non-top electrode connection ends, and a top surface of each of the protrusion portions is higher than a top surface of an inner side portion of the top electrode;
   the first resonator and the second resonator each include a conductive layer, which is in contact with a corresponding electrode in a thickness direction of the resonator, and the conductive layer is configured in such a manner that the protrusion portion is higher than the top surface of the inner side portion of the top electrode; and
   the conductive layer of the first resonator has a thickness different from a thickness of the conductive layer of the second resonator.
19. The assembly according to 18, wherein:
   the conductive layers of the first resonator and the second resonator are conductive layers arranged in the same layer.
20. A method of manufacturing the bulk acoustic resonator assembly according to 18, wherein the thickness of the conductive layer of the first resonator is greater than the thickness of the conductive layer of the second resonator, and the method includes the steps of:
   depositing a first deposition layer in a region where the first resonator and the second resonator are located;
   depositing a second deposition layer in a region corresponding to the first resonator on the first deposition layer; and
   patterning the first deposition layer and the second deposition layer to form the conductive layer of the first resonator and the conductive layer of the second resonator, the thickness of the conductive layer of the first resonator being the sum of a thickness of the first deposition layer and a thickness of the second deposition layer, and the thickness of the conductive layer of the second resonator being the thickness of the first deposition layer.
21. The method according to 20, wherein:
   the top electrodes of the first resonator and the second resonator are connected to each other; and
   the first deposition layer is deposited on upper surfaces of the piezoelectric layers of the first resonator and the second resonator.
22. An electronic device includes the bulk acoustic wave resonator assembly according to 18 or 19 or the filter according to any one of 1-17.

The electronic device herein includes, but is not limited to, intermediate products such as an RF front end, filter and amplifier modules, and terminal products such as mobile phones, WIFI, and drones.

Although the embodiments of the present disclosure have been shown and described, it should be understood for those skilled in the art that modifications may be made to these embodiments without departing from the principle and spirit of the present disclosure, and the scope thereof is defined by the appended claims and their equivalents.

## Claims

1. A filter, comprising:
a plurality of series resonators; and
a plurality of parallel resonators,
wherein each of the plurality of series resonator and the plurality of parallel resonators comprises a substrate, an acoustic mirror, a bottom electrode, a top electrode, and a piezoelectric layer;
wherein the top electrode of at least one series resonator of the plurality of series resonators and the top electrode of at least one parallel resonator of the plurality of parallel resonators have or are provided with protrusion portions at both top electrode connection ends and non-top electrode connection ends, and a top surface of each of the protrusion portions is higher than a top surface of an inner side portion of the top electrode;
wherein the resonators having the protrusion portions each comprise a conductive layer, the conductive layer is in contact with a corresponding electrode of the top electrode and the bottom electrode of the resonator in a thickness direction of the resonator, and the conductive layer is configured in such a manner that the protrusion portion is higher than the top surface of the inner side portion of the top electrode; and
wherein the conductive layer of the at least one series resonator has a thickness greater than a thickness of the conductive layer of the at least one parallel resonator.

2. The filter according to claim 1, wherein the thickness of the conductive layer of the at least one parallel resonator having the protrusion portions is less than a thickness of the corresponding electrode in contact therewith.

3. The filter according to claim 2, wherein the thickness of the conductive layer of the at least one parallel resonator having the protrusion portions is greater than the thickness of the corresponding electrode in contact therewith; or
the sum of the thickness of the conductive layer of the at least one series resonator having the protrusion portions and the thickness of the corresponding electrode in contact therewith is equal to or greater than 2000 Å.

4. The filter according to claim 3, wherein the conductive layer of the resonator having the protrusion portions is arranged between an upper surface of the piezoelectric layer and a lower surface of the top electrode.

5. The filter according to claim 4, wherein the top electrode of the resonator having the protrusion portions is provided with a conductive mass load layer, the conductive layer is in contact with the top electrode, and a thickness of the top electrode is the sum of the thickness of the top electrode and the thickness of the mass load layer.

6. The filter according to claim 3, wherein the conductive layer of the resonator having the protrusion portions is arranged below the piezoelectric layer and is in contact with the bottom electrode.

7. The filter according to claim 1, wherein the inner side portion is a convex polygonal region having a plurality of edges, the protrusion portions are arranged around the convex polygonal region to form a polygonal electrode frame, and the electrode frame comprises a plurality of frame edges.

8. The filter according to claim 7, wherein the plurality of frame edges of the electrode frame has different lateral widths in the acoustic mirror.

9. The filter according to claim 8, wherein the lateral width of at least one of the plurality of frame edges of the electrode frame in the acoustic mirror is different from the lateral width of at least one of the remaining frame edges of the plurality of frame edges in the acoustic mirror.

10. The filter according to claim 1, wherein the conductive layers of adjacent resonators are conductive layers arranged in the same layer.

11. The filter according to any one of claims 1-10, wherein at least two adjacent resonators of the filter are the resonators having the protrusion portions.

12. The filter according to claim 11, wherein the filter comprises a parallel resonator and a series resonator that are adjacent to each other, the top electrode of the parallel resonator is connected with the top electrode of the series resonator, and the conductive layers of the parallel resonator and the series resonator that are adjacent to each other are arranged between the top electrode and the piezoelectric layer; or
the filter comprises a parallel resonator and a series resonator that are adjacent to each other, the top electrode of the parallel resonator is connected with the top electrode of the series resonator, the conductive layers of the parallel resonator and the series resonator that are adjacent to each other are arranged on an upper surface of the top electrode, and the conductive layers form the protrusion portions.

13. The filter according to claim 11, wherein the filter comprises adjacent series resonators of which the top electrodes are connected to each other, and each of the conductive layers of the adjacent series resonators is arranged between the top electrode and the piezoelectric layer; or
the filter comprises adjacent series resonators of which the top electrodes are connected to each other, each of the conductive layers of the adjacent series resonators is arranged on the upper surface of the top electrode, and the conductive layer forms the protrusion portion.

14. The filter according to claim 11, wherein the filter comprises adjacent series resonators of which the bottom electrodes are connected to each other, and each of the conductive layers of the adjacent series resonator is arranged below the piezoelectric layer and is in contact with the bottom electrode; or
the filter comprises a series resonator and a parallel resonator that are adjacent to each other, the bottom electrode of the series resonator is connected with the bottom electrode of the parallel resonator, and each of the conductive layers of the series resonator and the parallel resonator that are adjacent to each other is arranged below the piezoelectric layer and is in contact with the bottom electrode.

15. The filter according to claim 12, wherein in the parallel resonator and series resonator that are adjacent to each other, in an electrode connection region between the parallel resonator and series resonator, the conducive layer of the series resonator is connected to the conducive layer of the parallel resonator on an outer side of an effective region of the parallel resonator.

16. The filter according to claim 15, wherein the conductive layer of the series resonator extends across at least 50% of an area of the electrode connection region.

17. The filter according to claim 13, wherein in the adjacent series resonators, the conductive layers of the series resonators extend across the entire electrode connection region between the adjacent series resonators.

18. A bulk wave acoustic resonator assembly, comprising:
a first resonator and a second resonator, both of which are bulk acoustic wave resonators, each of the first resonator and the second resonator comprising a substrate, an acoustic mirror, a bottom electrode, a top electrode, and a piezoelectric layer, the top electrodes of the first resonator and the second resonator being connected to each other or the bottom electrodes of the first resonator and the second resonator being connected to each other,
wherein the top electrodes of the first resonator and the second resonator have or are provided with protrusion portions at both top electrode connection ends and non-top electrode connection ends, and a top surface of each of the protrusion portions is higher than a top surface of an inner side portion of the top electrode;
wherein the first resonator and the second resonator each comprise a conductive layer, which is in contact with a corresponding electrode in a thickness direction of the resonator, and the conductive layer is configured in such a manner that the protrusion portion is higher than the top surface of the inner side portion of the top electrode; and
wherein the conductive layer of the first resonator has a thickness different from a thickness of the conductive layer of the second resonator.

19. The assembly according to claim 18, wherein the conductive layers of the first resonator and the second resonator are conductive layers arranged in the same layer.

20. A method of manufacturing the bulk acoustic resonator assembly according to claim 18, wherein the thickness of the conductive layer of the first resonator is greater than the thickness of the conductive layer of the second resonator, and the method comprises:
depositing a first deposition layer in a region where the first resonator and the second resonator are located;
depositing a second deposition layer in a region corresponding to the first resonator on the first deposition layer; and
patterning the first deposition layer and the second deposition layer to form the conductive layer of the first resonator and the conductive layer of the second resonator, the thickness of the conductive layer of the first resonator being the sum of a thickness of the first deposition layer and a thickness of the second deposition layer, and the thickness of the conductive layer of the second resonator being the thickness of the first deposition layer.

21. The method according to claim 20, wherein the top electrodes of the first resonator and the second resonator are connected to each other; and
the first deposition layer is deposited on upper surfaces of the piezoelectric layers of the first resonator and the second resonator.

22. An electronic device, comprising the bulk acoustic wave resonator assembly according to claim 18 or 19 or the filter according to any one of claims 1-17.
